(19) Europäisches Patentamt / European Patent Office / Office européen des brevets

(11) **EP 4 733 216 A1**

(12) **EUROPEAN PATENT APPLICATION**
published in accordance with Art. 153(4) EPC

(43) Date of publication:
**29.04.2026 Bulletin 2026/18**

(21) Application number: **24826041.6**

(22) Date of filing: **24.06.2024**

(51) International Patent Classification (IPC):
**B65D 25/14** *(2006.01)*     **B65D 65/40** *(2006.01)*
**B65D 85/72** *(2006.01)*     **C23C 16/42** *(2006.01)*

(52) Cooperative Patent Classification (CPC):
**B65D 25/14; B65D 65/40; B65D 85/72; C23C 16/42**

(86) International application number:
**PCT/JP2024/022822**

(87) International publication number:
**WO 2024/262640 (26.12.2024 Gazette 2024/52)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 23.06.2023   JP 2023103050
25.01.2024   JP 2024009397

(71) Applicant: **THE NISSHIN OILLIO GROUP, LTD.**
**Tokyo 104-8285 (JP)**

(72) Inventors:
- **METOKI, Junya**
  **Yokohama-shi, Kanagawa 235-8558 (JP)**
- **MURANO, Yoshihiro**
  **Yokohama-shi, Kanagawa 235-8558 (JP)**
- **KURIMOTO, Takayuki**
  **Yokohama-shi, Kanagawa 235-8558 (JP)**
- **HAYAKAWA, Tetsuhiko**
  **Yokohama-shi, Kanagawa 235-8558 (JP)**
- **OTSUBO, Yuki**
  **Yokohama-shi, Kanagawa 235-8558 (JP)**

(74) Representative: **Hasegawa, Kan**
**Patentanwaltskanzlei Hasegawa**
**Untere Hauptstraße 56**
**85354 Freising (DE)**

(54) **CONTAINER FOR HOLDING OIL/FAT COMPOSITION**

(57)     An object of the present invention is to provide a container for holding an oil/fat composition having a silicon oxide vapor-deposited film with good oil drainage. Provided is a container for holding an oil/fat composition having a silicon oxide vapor-deposited film on an inner surface of the container. The container has a roll-off property of oils and/or fats on the inner surface of the container of 300 seconds or less. The roll-off property of oils and/or fats is measured based on the time (seconds) for an oil and/or fat droplet of rapeseed oil of $24\pm0.5$ mg to move 6 mm on the sample surface inclined at 70° with respect to the vertical at $23\pm3$°C.

EP 4 733 216 A1

**Description**

Technical Field

The present invention relates to a container for holding an oil/fat composition (oil and/or fat composition) having a silicon oxide vapor-deposited film. The present invention particularly relates to a container for holding an oil/fat composition with good oil drainage.

Background Art

Conventionally, forming a film on a surface has been performed to improve the properties of various substrates. For example, in packaging materials, a vapor-deposited film is formed by a plasma CVD method on the surface of a plastic formed article to improve gas barrier properties.

For example, a method for producing a plastic container is known wherein the concentration of an organosilicon compound is changed when forming a barrier layer (vapor-deposited film) containing a silicon oxide and at least one compound composed of at least one element selected from carbon, hydrogen, silicon, and oxygen, on at least one side of a plastic container by a plasma CVD method using at least an organosilicon compound and oxygen or a gas having oxidizing power. The gas flow rate ratio between the organosilicon compound (hexamethyldisiloxane) and oxygen was 1:2, 1:20, and 1:100 (see Patent Literature 1).

It has been shown that a silicon oxide film produced with a flow rate ratio of an organosilicon compound gas to a gas containing oxygen atoms in a range of 1:3 to 50, and having a component ratio of 170 to 200 O atoms and 30 or less C atoms per 100 Si atoms, has gas barrier properties (see Patent Literature 2).

On the other hand, for articles such as containers and cooking utensils, if cleanability after use and dischargeability of contents are good, workability improves and the environmental load is also reduced. For this reason, water or oil repellency is also required as a property of substrates such as containers and cooking utensils. For water repellency, for example, a bottle with good drainage properties has been proposed, which is obtained by depositing an organosilicon compound film containing nitrogen, silicon, carbon, and hydrogen, and forming a silicon oxide compound film mainly composed of a silicon oxide compound on its surface by a CVD method (gas flow rate ratio of hexamethyldisiloxane to oxygen of 1:4) (see Patent Literature 3). Also, a functional material has been proposed in which a functional layer is specified by an elemental ratio of carbon-containing silicon oxide (see Patent Literature 4). However, a silicon oxide compound film focusing on the roll-off property of oils or the like from a storage container for oils and/or fats has not been studied so far.

Citation List

Patent Literatures

Patent Literature 1: Japanese Unexamined Patent Application Publication No. 2000-255579
Patent Literature 2: Japanese Unexamined Patent Application Publication No. 2003-53873
Patent Literature 3: Japanese Unexamined Patent Application Publication No. 2009-46162
Patent Literature 4: Japanese Unexamined Patent Application Publication No. 2022-162775

Summary of Invention

One object of the present invention is to provide a container for holding an oil/fat composition coated with a silicon oxide vapor-deposited film, which has good oil drainage.

As a result of diligent studies, the present inventors have found that a container having good oil drainage performance can be obtained by adjusting the roll-off property of an oil/fat composition on an inner surface of the container, and have completed the present invention.

One aspect of the present invention may relate to the following.

[1] A container for holding an oil/fat composition having a silicon oxide vapor-deposited film on an inner surface, wherein a roll-off property of oils and/or fats on the inner surface of the container according to the following definition is 300 seconds or less.

Roll-off property of oils and/or fats: time (seconds) for an oil and/or fat droplet of rapeseed oil having a mass of $24 \pm 0.5$ mg to move 6 mm on a sample surface inclined at 70° with respect to the vertical at $23 \pm 3°C$.

[2] The container for holding an oil/fat composition according to [1], wherein a reduction ratio of a residual oils and/or fats amount of the container according to the following definition is 20% by mass or more:

Reduction ratio of residual oils and/or fats amount: a value that satisfies the following formula, wherein A is the amount (% by mass) of the oil/fat composition remaining in the container 600 seconds after the oil/fat composition starts discharging from an opening of the container when the container filled with the oil/fat composition is inclined to 160° with respect to the vertical; and B is the amount (% by mass) of the oil/fat composition, measured in the same manner, remaining in a container identical to the container for holding an oil/fat composition except that it does not have a silicon oxide vapor-deposited film on an inner surface:

$$\text{Reduction ratio of residual oils and/or fats amount (\%)} = (1-A/B) \times 100$$

[3] The container for holding an oil/fat composition according to [1] or [2], wherein the container for holding an oil/fat composition is formed from a material selected from the group consisting of resin, glass, paper, and metal.
[4] The container for holding an oil/fat composition according to any one of [1] to [3], wherein the silicon oxide vapor-deposited film is a film derived from hexamethyldisiloxane.
[5] The container for holding an oil/fat composition according to any one of [1] to [4], wherein an oil/fat composition is held.

According to the present invention, a container for holding an oil/fat composition having a silicon oxide vapor-deposited film that exhibits good oil drainage performance can be provided. In addition, a container having a surface coated with the silicon oxide vapor-deposited film is expected to have good oil drainage and allow easy removal of oil and/or fat stains, thus providing excellent cleanability. Also, the container of the present invention is expected to allow the held oil/fat composition to be used up to the end, make it less likely for residual oils/fats or the like to occur in the container, and improve the recyclability of the container.

Description of Embodiments

Hereinafter, the present invention will be described in detail with examples. In the embodiments of the present invention, A (numerical value) to B (numerical value) means A or more and B or less. Preferred aspects, more preferred aspects, and the like exemplified below can be used in appropriate combination with each other, regardless of expressions such as "preferred" or "more preferred." Also, the description of a numerical range is an example, and a range in which the upper limit and the lower limit of each range and the numerical values of the examples are appropriately combined can also be preferably used, regardless of expressions such as "preferred" or "more preferred." Furthermore, terms such as "containing" or "including" may be appropriately read as "consisting essentially of" or "consisting of."

[Container for Holding an Oil/Fat Composition]

The container for holding an oil/fat composition described in this specification comprises a silicon oxide vapor-deposited film on an inner surface, wherein a roll-off property of oils and/or fats on the inner surface of the container, according to the following definition, is:

Roll-off property of oils and/or fats: the time (seconds) required for an oil and/or fat droplet of rapeseed oil having a mass of $24\pm0.5$ mg to move 6 mm on the sample surface inclined at 70° with respect to the vertical at $23°C\pm3°C$, 300 seconds or less.

The container for holding an oil/fat composition described in this specification provides a container for holding an oil/fat composition with good oil drainage by adjusting the roll-off property of the oils and/or fats as described above. Oil repellency and water repellency are indicators of the separability between a liquid or paste, such as oils and/or fats, and a container holding it. However, oil repellency and water repellency differ in their effects and the range of conditions under which the effects are exhibited. Furthermore, even if oil repellency is good, it does not necessarily ensure excellent oil drainage that leaves no oils and/or fats in the container. Without being bound by theory, this is thought to be because oil repellency and water repellency are related to static contact between the container surface and the liquid, whereas oil drainage is related to dynamic contact between the container surface and the oils and/or fats. Therefore, the present invention focuses on the roll-off property of oils and/or fats on the surface of a container for holding an oil/fat composition to provide a container with good oil drainage. Furthermore, by focusing on the roll-off property of an oil/fat composition, in addition to the roll-off property of oils and/or fats, the present invention provides a container for holding an oil/fat composition with even better oil drainage. Here, the container for holding an oil/fat composition refers to a container suitable for holding oils and/or fats or a composition containing oils and/or fats, and the oil/fat composition is meant to include not only oils and/or fats alone but also any product containing oils and/or fats (oils and/or fats or an oil/fat composition). Also, the oil/fat composition is preferably, for example, liquid or fluid at 20°C. In this specification, references to "oil" in terms such as "oil drainage" or "oil repellency" refer not only to liquid oil but also to oils and/or fats and any product containing oils and/or fats (oil/fat composition). Also, in this specification, "oil," "oils and/or fats," and "oil/fat composition" may be interchanged with each other.

(Roll-off property of Oils and/or Fats or Oil/Fat Composition)

The roll-off property of oils and/or fats or an oil/fat composition is measured based on the time (seconds) for an oil and/or fat droplet (or liquid droplet) such as rapeseed oil having a mass of $24 \pm 0.5$ mg to move 6 mm on the sample surface inclined at 70° with respect to the vertical at $23 \pm 3$°C. The measurement is performed with reference to the rear end of an oil and/or fat droplet (or liquid droplet) such as rapeseed oil, wherein the rear end is defined as the uppermost point of contact between the sample surface and the oil and/or fat droplet on the inclined sample surface. The rapeseed oil may be dropped onto the sample surface inclined at 70° with respect to the vertical. Alternatively, the measurement may be conducted by dropping the rapeseed oil onto a horizontally placed sample surface and then inclining it to 70° with respect to the vertical. The sample to be measured is a container for holding an oil/fat composition, and may be measured as it is, or a smooth part of the container for holding an oil/fat composition to be measured may be cut out and measured as a flat or substantially flat sample. As a method for inclining the sample to 70° with respect to the vertical, a known method can be used, but for example, "Stage AG85 (angle tilt)" manufactured by AS ONE Corporation or the like may be used.
The oils and/or fats dropped onto the sample surface of the container for holding an oil/fat composition is, for example, rapeseed oil. As rapeseed oil, a refined one can be used, and rapeseed oil sold for food or rapeseed oil sold as a reagent can be used. As rapeseed oil sold for food, one categorized as "refined rapeseed oil" or "rapeseed salad oil" in "edible rapeseed oil" of the JAS standard ("Japanese Agricultural Standard for Edible Vegetable Oils and Fats," Ministry of Agriculture, Forestry and Fisheries Notification No. 681 of August 19, 2019) can be used. For example, "Nisshin Canola Oil" (manufactured by The Nisshin OilliO Group, Ltd.) or the like can be used. Also, as a reagent, "Rapeseed Oil" (manufactured by Fujifilm Wako Pure Chemical Corporation: Wako 1st Grade) or the like can be used. Note that an oil-soluble coloring agent may be added to improve the visibility of the rapeseed oil. For example, about 0.1% by mass of β-carotene can be added to the rapeseed oil. The addition of this amount of β-carotene does not substantially affect the roll-off property value of the oils and/or fats themselves (the roll-off property value of the oils and/or fats does not substantially change with or without β-carotene). Refined rapeseed oil usually contains 51 to 66% by mass of oleic acid, 19 to 28% by mass of linoleic acid, 2 to 11% by mass of linolenic acid, 3 to 6% by mass of palmitic acid, and 1 to 3% by mass of stearic acid. The amount of the mixture of the above oils and/or fats dropped is $24 \pm 0.5$ mg, and is preferably about 24.36 mg, which corresponds to one drop from a commercially available dropper. Also, when storing an oil/fat composition in a container, an emulsified dressing, a separated dressing, or various other compositions containing oils and/or fats may be used instead of the oils and/or fats, and the roll-off property may be measured in the same manner as above. Note that an emulsified dressing is a dressing in which oils and/or fats is emulsified, and also includes mayonnaise or a mayonnaise-type dressing.
The test of the roll-off property of oils and/or fats is performed by placing the specified amount of rapeseed oil on the sample surface of the container for holding an oil/fat composition, which is inclined at 70° with respect to the vertical, at $23 \pm 3$°C (start of measurement), and measuring the time (in seconds) required for the rear end of the placed oil and/or fat droplet to move 6 mm. The roll-off property of the oils and/or fats measured under these conditions is preferably within 300 seconds from the start of measurement, for example, more than 60 seconds to 300 seconds, more preferably more than 20 seconds to 60 seconds, still more preferably more than 10 seconds to 20 seconds, and particularly preferably no more than 10 seconds.

(Residual Oil and/or Fat Amount)

Also, the reduction ratio of the residual oils and/or fats amount (the amount of residual oil/fat composition in the case of an oil/fat composition) of the storage container described in this specification is preferably 40% by mass or more, more preferably 50% by mass or more or 60% by mass or more, still more preferably 80% by mass or more, and most preferably 90% by mass or more. Here, the measurement method and definition of the reduction ratio of the residual oils and/or fats amount are as follows.
First, a container for holding an oil/fat composition, having an opening at an upper end (the upper end is open and the lower end is closed), is prepared and filled with oils and/or fats or an oil/fat composition. Two types of containers for holding an oil/fat composition are used: a container having a silicon oxide vapor-deposited film, which is the object of evaluation for the reduction ratio of residual oils and/or fats amount, on the inner surface of the container, and an untreated container which is identical to the container for holding an oil/fat composition except that it does not have a silicon oxide vapor-deposited film on the inner surface of the container. In general, since the silicon oxide vapor-deposited film is formed after the container is molded, a container immediately after molding that has not undergone the silicon oxide vapor-deposition step may be used as the untreated container for holding an oil/fat composition.

Regarding the shape of the container, since the influence of the container shape on the residual oils and/or fats amount is canceled by measuring and comparing the residual oils and/or fats amount of a container having a silicon oxide vapor-deposited film on its inner surface and the residual oils and/or fats amount of a container not having a silicon oxide vapor-deposited film on its inner surface, it is not limited, but for example, a bottle shape, a cylindrical shape, or a bag shape (pillow bag) is preferable.

Note that the filling amount of the oil/fat composition corresponds to the usable capacity of the container; for example, for a container sold filled with 600 g of edible oils and/or fats, the filling amount is 600 g. In general, the filling amount in a container for an oil/fat composition is often set to occupy 90% or more of the full container capacity. The filling amount of the container is preferably 90 to 2,000 g, more preferably 150 to 1,300 g, and still more preferably 400 to 800 g.

Regarding the material of the container, since the influence of the container material on the residual oils and/or fats amount is canceled by measuring and comparing the residual oils and/or fats amount of a container having a silicon oxide vapor-deposited film on its inner surface and the residual oils and/or fats amount of a container not having a silicon oxide vapor-deposited film on its inner surface, it is not limited.

Regarding the oils and/or fats to be filled, since variations in analysis due to differences in oils/fats are canceled by measuring and comparing the residual oils and/or fats amount of a container having a silicon oxide vapor-deposited film on its inner surface and the residual oils and/or fats amount of a container not having a silicon oxide vapor-deposited film on its inner surface using the same type of oils and/or fats, it is not limited. It is preferable to use oils and/or fats having a triglyceride structure as the oils and/or fats to be measured, because similar physical properties can be expected for other triglycerides, and the reduction ratio of the residual oils and/or fats amount can also be expected to be a similar value. For example, as those having a triglyceride structure, animal and vegetable oils and/or fats, processed oils and/or fats thereof, and synthetic oils are preferable. Also, these may be used alone, or mixed oils or fractionated oils may be used. Animal and vegetable oils and/or fats include rapeseed oil, soybean oil, corn oil, cottonseed oil, safflower oil, sunflower oil, sesame oil, perilla oil, linseed oil, peanut oil, palm oil, palm kernel oil, coconut oil, and the like. Note that since the temperature at which it is actually discharged from the container is above the melting point of the oils and/or fats, and the residual oils and/or fats amount may be measured above the melting point, solid fats can also be used. More preferably, it is a liquid oil at 20°C, and the aforementioned rapeseed oil is still more preferable.

The container for holding an oil/fat composition filled with an oil/fat composition and having an opening at its upper end is quickly inclined to an angle of 160° with respect to the vertical. Specifically, the container for holding an oil/fat composition is inclined from an upright state (0° with respect to the vertical: a state where the opening faces vertically upward) to 160° with respect to the vertical (a state where the opening positioned vertically below the bottom of the container), thereby discharging the oils and/or fats from the upper opening of the container. The time when the oil/fat composition then starts to be discharged from the container opening is defined as 0 seconds, and the amount of the oil/fat composition remaining in the container after 600 seconds have elapsed is measured as the residual oils and/or fats amount. The elapsed time may be further set to 150 seconds, 200 seconds, or 300 seconds. Here, the reduction ratio of the residual oils and/or fats amount can be determined from the following formula, wherein the residual oils and/or fats amount of the container for holding an oil/fat composition having a silicon oxide vapor-deposited film on its inner surface is taken as residual oils and/or fats amount A (% by mass), and the residual oils and/or fats amount of a container identical to the container for holding an oil/fat composition except that it does not have a silicon oxide vapor-deposited film on its inner surface is taken as residual oils and/or fats amount B (% by mass):

$$\text{Reduction ratio of residual oils and/or fats amount (\%)}=(1-A/B) \times 100.$$

(Silicon Oxide Vapor-Deposited Film)

The container for holding an oil/fat composition of the present invention is a container for holding an oil/fat composition in which at least its inner surface is coated with the aforementioned silicon oxide vapor-deposited film. The surface coating may be on all or part of the inner and outer surfaces of the container for holding an oil/fat composition, but by having the silicon oxide vapor-deposited film on the outermost layer of the inner surface of the container for holding an oil/fat composition, the dischargeability of the oils and/or fats, which is the content, becomes good. Also, for the silicon oxide vapor-deposited film of the present invention, another coating may be present between the substrate of the coated container for holding an oil/fat composition and the coating layer of the silicon oxide vapor-deposited film.

In the present invention, for the silicon oxide vapor-deposited film, the effect of the present invention can be obtained by selecting one with a roll-off property of oils and/or fats on the inner surface of the container of 300 seconds or less. As the silicon oxide vapor-deposited film having such roll-off property, for example, the following silicon oxide vapor-deposited film can be used.

A surface of the silicon oxide vapor-deposited film has a ratio of the sum of an intensity of an ion a (ion intensity A) and an intensity of an ion ao (ion intensity AO) to an intensity of an ion s (ion intensity S) ((ion intensity A+ion intensity AO)/ion intensity S) of 10 or more, and/or, a ratio of ion intensity AO to ion intensity S (ion intensity AO/ion intensity S) of 0.7 or more, in an ion intensity spectrum obtained by time-of-flight secondary ion mass spectrometry.

As another aspect, the silicon oxide vapor-deposited film of the present invention is a silicon oxide vapor-deposited film wherein a surface of the silicon oxide vapor-deposited film has (a) a ratio of ion intensity AO to an intensity of an ion b (ion intensity B) (ion intensity AO/ion intensity B) of 3 or more in an ion intensity spectrum obtained by time-of-flight secondary ion mass spectrometry. The silicon oxide vapor-deposited film of the present invention is preferably a silicon oxide vapor-deposited film wherein a surface of the silicon oxide vapor-deposited film has (b) a ratio of ion intensity AO to ion intensity A (ion intensity AO/ion intensity A) of 0.1 or more or 0.2 or more, and/or, (c) a ratio of the sum of ion intensities A and AO to ion intensity S ((ion intensity A+ion intensity AO)/ion intensity S) of 10 or more, and/or, (d) a ratio of ion intensity AO to ion intensity S (ion intensity AO/ion intensity S) of 0.7 or more, in an ion intensity spectrum obtained by time-of-flight secondary ion mass spectrometry.

Here, ion s, ion a, ion ao, ion b, ion intensity S, ion intensity A, ion intensity AO, and ion intensity B are as follows.

Ion s refers to the positive ion at m/z 43.97.

Ion a refers to the group of positive ions consisting of the positive ion at m/z 43.00, the positive ion at m/z 59.03, and the positive ion at m/z 73.05.

Ion ao refers to the group of ions consisting of the negative ion at m/z 31.02, the negative ion at m/z 59.00, the negative ion at m/z 74.99, the positive ion at m/z 102.97, and the negative ion at m/z 134.96.

Ion b refers to the group of positive ions consisting of the positive ion at m/z 78.99, and the positive ion at m/z 138.95.

The ion intensity S is the intensity of the positive ion at m/z 43.97.

The ion intensity A is the sum of intensities of the positive ion at m/z 43.00, the positive ion at m/z 59.03, and the positive ion at m/z 73.05.

The ion intensity AO is the sum of intensities of the negative ion at m/z 31.02, the negative ion at m/z 59.00, the negative ion at m/z 74.99, the positive ion at m/z 102.97, and the negative ion at m/z 134.96.

The ion intensity B is the sum of intensities of the positive ion at m/z 78.99, and the positive ion at m/z 138.95.

Note that in the present invention, ions detected in time-of-flight secondary ion mass spectrometry are identified by m/z (a value obtained by dividing the mass m of an ion by the valence of the ion: a dimensionless quantity value). Also, the intensity of an ion (ion intensity) is a value that depends on the number of ions detected by time-of-flight secondary ion mass spectrometry (a value detected for each ion at each m/z).

The silicon oxide vapor-deposited film of the present invention can be produced by a plasma CVD method using a reactive gas containing an organosilicon compound, and it is presumed that roll-off property and/or oil repellency for oils and/or fats or an oil and/or fat-containing composition are exhibited by allowing alkyl groups and/or alkoxy groups to remain in the silicon oxide vapor-deposited film in a certain amount or more, and/or, by allowing hydroxyl groups and alkoxy groups to remain in the silicon oxide vapor-deposited film at a certain ratio.

Since the content of components including hydroxyl groups and/or alkoxy groups and/or alkyl groups in the silicon oxide vapor-deposited film correlates with the intensity of peaks derived from functional groups obtained by time-of-flight secondary ion mass spectrometry (TOF-SIMS) of the surface of the silicon oxide vapor-deposited film, the silicon oxide vapor-deposited film of the present invention requires that the ion intensity of ions presumed to contain hydroxyl groups and/or alkoxy groups and/or alkyl groups be a certain ratio with respect to the ion intensity of ions presumed to be derived only from silicon oxide in time-of-flight secondary ion mass spectrometry.

Note that the ion presumed to be derived only from silicon oxide (ion s) is the positive ion at m/z 43.97 (SiO), and the ion intensity of this ion is the ion intensity S. Also, the ions presumed to contain an alkyl group (ion a) are the positive ion at m/z 43.00 ($SiCH_3$), the positive ion at m/z 59.03 ($SiC_2H_7$), and the positive ion at m/z 73.05 ($SiC_3H_9$), and the sum of these ion intensities is the ion intensity A. Also, the ions presumed to contain an alkoxy group (ion ao) are the negative ion at m/z 31.02 ($CH_3O$), the negative ion at m/z 59.00 ($SiCH_3O$), the negative ion at m/z 74.99 ($SiCH_3O_2$), the positive ion at m/z 102.97 ($Si_2CH_3O_2$), and the negative ion at m/z 134.96 ($Si_2CH_3O_4$), and the sum of these ion intensities is the ion intensity AO. Furthermore, the ions presumed to contain a hydroxyl group (ion b) are the positive ion at m/z 78.99 ($SiO_3H_3$), and the positive ion at m/z 138.95 ($Si_2O_5H_3$), and the sum of these ion intensities is the ion intensity B.

The silicon oxide vapor-deposited film of the present invention is a silicon oxide vapor-deposited film in which (a) the ratio of ion intensity AO to ion intensity B (ion intensity AO/ion intensity B) at a surface of the film is preferably 3 or more, more preferably 6 or more, still more preferably 8 or more, even more preferably 12 or more, and particularly preferably 14 or more, in an ion intensity spectrum obtained by time-of-flight secondary ion mass spectrometry. The silicon oxide vapor-deposited film of the present invention is preferably a silicon oxide vapor-deposited film in which, in the ion intensity spectrum obtained by time-of-flight secondary ion mass spectrometry of the surface of the silicon oxide vapor-deposited film, (b) the ratio of ion intensity AO to ion intensity A (ion intensity AO/ion intensity A) is 0.1 or more or 0.2 or more, may be preferably 1.8 or more or 1.9 or more, and is more preferably 2.0 or more. As another aspect, the silicon oxide vapor-deposited film of the present invention is a silicon oxide vapor-deposited film in which, in an ion intensity spectrum obtained by time-of-flight secondary ion mass spectrometry of the surface of the silicon oxide vapor-deposited film, (c) the ratio of the sum of ion intensities A and AO to ion intensity S ((ion intensity A+ion intensity AO)/ion intensity S) is 10 or more, may be preferably 20 or more, is more preferably 30 or more, and is still more preferably 33 or more.

Also, the silicon oxide vapor-deposited film of the present invention is a silicon oxide vapor-deposited film in which, in an ion intensity spectrum obtained by time-of-flight secondary ion mass spectrometry of the surface of the silicon oxide vapor-deposited film, (a)' the ratio of ion intensity AO to ion intensity B (ion intensity AO/ion intensity B) is preferably 20,000 or less or 14,000 or less, and is more preferably any of 500 or less, 200 or less, 100 or less, 50 or less, or 40 or less. Also, the silicon oxide vapor-deposited film of the present invention is a silicon oxide vapor-deposited film in which, in an ion intensity spectrum obtained by time-of-flight secondary ion mass spectrometry of the surface of the silicon oxide vapor-deposited film, (b)' the ratio of ion intensity AO to ion intensity A (ion intensity AO/ion intensity A) is preferably 5 or less, and more preferably 3 or less or 1 or less. Also, the silicon oxide vapor-deposited film of the present invention is a silicon oxide vapor-deposited film in which, in an ion intensity spectrum obtained by time-of-flight secondary ion mass spectrometry of the surface of the silicon oxide vapor-deposited film, (c)' the ratio of the sum of the ion intensities A and AO to ion intensity S ((ion intensity A+ion intensity AO)/ion intensity S) is preferably 60,000 or less or 45,000 or less, more preferably 1,000 or less or 600 or less, still more preferably 100 or less, and particularly preferably 80 or less.

As another aspect, the silicon oxide vapor-deposited film of the present invention is a silicon oxide vapor-deposited film in which, in an ion intensity spectrum obtained by time-of-flight secondary ion mass spectrometry of the surface of the silicon oxide vapor-deposited film, (d) the ratio of ion intensity AO to ion intensity S (ion intensity AO/ion intensity S) may be 0.7 or more, is preferably 0.8 or more, more preferably 1 or more, still more preferably 5 to 500, and particularly preferably 7 to 250. As still another aspect, a silicon oxide vapor-deposited film of the present invention is the silicon oxide vapor-deposited film in which, in an ion intensity spectrum obtained by time-of-flight secondary ion mass spectrometry, a surface of the silicon oxide vapor-deposited film has (d)' a ratio of ion intensity AO to ion intensity S (ion intensity AO/ion intensity S) that may be 0.7 or more, is preferably 1 to 200, still more preferably 10 to 150, and most preferably 20 to 50.

Also, in the ion intensity, it is preferable that (e) a ratio of ion intensity A to ion intensity S (ion intensity A/ion intensity S) is 5 or more, more preferably 6 or more, still more preferably 7 or more, and particularly preferably 40 or more.

Regarding the effect of the alkyl groups and alkoxy groups in the silicon oxide vapor-deposited film on oil repellency and the roll-off property of oils and/or fats, a higher content of alkoxy groups relative to alkyl groups results in higher oil repellency and roll-off property of oils and/or fats, and for this reason, in the peak, it is preferable that (f) a ratio of the ion intensity AO to the ion intensity A (ion intensity AO/ion intensity A) is preferably 0.2 or more, more preferably 0.5 or more, and still more preferably 1 or more.

Here, the conditions of the above (a) to (f) and (a)' to (c)' may satisfy or not satisfy two or more of the conditions of (a) to (f) and (a)' to (c)' in combination. Preferably, it is a combination of (a) and any one or more of (b) to (f) and (a)' to (c)', or a combination of (c) or (c)' and (d), and optionally a combination with one or more of the conditions of (a), (b), and (e) to (f).

Note that in the present invention, time-of-flight secondary ion mass spectrometry can be measured using a commercially available apparatus, and for example, a time-of-flight secondary ion mass spectrometer ("TOF.SIMS5" manufactured by ION-TOF GmbH, Germany, measurement area: 500 $\mu$m square, primary ion source: Bi) sold by Hitachi High-Tech Science Corporation can be used.

For the silicon oxide vapor-deposited film of the present invention, since good oil repellency and roll-off property for oils and/or fats can be achieved by covering the surface, the thickness of the film is considered not to have a particular influence. The thickness of the film is not particularly limited, but is preferably 1 to 800 nm, more preferably 5 to 500 nm, still more preferably 8 to 400 nm, even more preferably 10 to 300 nm, and most preferably 10 to 150 nm.

The thickness of the silicon oxide vapor-deposited film can be measured, for example, with a microscopic automatic film thickness measurement system (model number: F54 XY 200UV) manufactured by Filmetrics, Inc., a stylus-type film thickness meter "DEKTAK" manufactured by Bruker Corporation, or by preparing a cross-section of the film and using a field emission scanning electron microscope "JSM-7800F Prime" (magnification 30,000x, acceleration voltage 2 kV, working distance 10.3 mm) manufactured by JEOL Ltd. Note that the portion of the container for holding an oil/fat composition to be coated with the silicon oxide vapor-deposited film may be the whole or a part of the container, and in particular, may be only the surface portion that comes into contact with the oils and/or fats.

In the container for holding an oil/fat composition of the present invention, the contact angle of rapeseed oil at 23 $\pm$3°C on the surface covered with the aforementioned silicon oxide vapor-deposited film is preferably 20° or more, more preferably 20 to 90°, still more preferably 25 to 80°, and most preferably 30 to 60°. Here, the rapeseed oil is as described above.

(Material/Part of Container for Holding an Oil/Fat Composition)

The container for holding an oil/fat composition (substrate) of the present invention is preferably formed from a material selected from the group consisting of resin, glass, paper, ceramics, and metal, and resin is more preferable. By providing the aforementioned silicon oxide vapor-deposited film on the inner surface of the container for holding an oil/fat composition, a container for holding an oil/fat composition endowed with prevention of oil and/or fat stains and improvement in oil and/or fat removability can be obtained. Suitable resins include thermoplastic resins known per se, for example, low-density polyethylene, high-density polyethylene, polypropylene, poly-1-butene, poly-4-methyl-1-pentene, polyolefins (for example, polyolefins such as random or block copolymers of α-olefins such as ethylene, propylene, 1-butene, 4-methyl-1-pentene), ethylene-vinyl compound copolymers (for example, ethylene-vinyl acetate copolymer, ethylene-vinyl alcohol copolymer, ethylene-vinyl chloride copolymer, and the like), styrenic resins (for example, polystyrene, acrylonitrile-styrene copolymer, ABS, α-methylstyrene-styrene copolymer, and the like), polyvinyl compounds (for example, polyvinyl chloride, polyvinylidene chloride, vinyl chloride-vinylidene chloride copolymer, polymethyl acrylate, polymethyl methacrylate, and the like), polyamides (for example, nylon 6, nylon 6-6, nylon 6-10, nylon 11, nylon 12, and the like), thermoplastic polyesters (for example, polyethylene terephthalate, polybutylene terephthalate, polyethylene naphthalate, and the like), polycarbonate, polyphenylene oxide, biodegradable resins such as polylactic acid, or any mixture thereof. More preferably, it is a resin such as polyethylene or polyethylene terephthalate. Also, as the metal, one or more metals selected from iron, nickel, copper, zinc, lead, aluminum, chromium, titanium, and the like, or an alloy containing one or more of these metals as a main component is preferable, and stainless steel is more preferable.

These containers for holding an oil/fat composition include bottles, tanks, pillow bags, cups, deep dishes, containers, and the like, and lids, caps, handles, nozzles, and the like that constitute a container can also be recognized as a part of the container. As the container for holding an oil/fat composition, formed articles such as bottles, tanks, pillow bags, and containers for oils and/or fats are particularly preferable.

(Oil/Fat Composition to be Held)

The container for holding an oil/fat composition of the present invention may be a container for holding an oil/fat composition in which oils and/or fats and/or an oil/fat composition is held.

As the oils and/or fats held in the container for holding an oil/fat composition, for example, one having a triglyceride structure is preferable, and animal and vegetable oils and/or fats, processed oils and/or fats thereof, and synthetic oils are preferable. Also, these may be used alone, or mixed oils or fractionated oils may be used. Animal and vegetable oils and/or fats include rapeseed oil, soybean oil, corn oil, cottonseed oil, safflower oil, sunflower oil, sesame oil, perilla oil, linseed oil, peanut oil, palm oil, palm kernel oil, coconut oil, and the like. Also, mixed oils or fractionated oils thereof may be used. More preferably, it is a liquid oil at 20°C, and the aforementioned rapeseed oil is still more preferable. It is preferably edible.

Also, an oil/fat composition in which an emulsifier, an antifoaming agent, an antioxidant, or the like is dispersed or dissolved in the oil/fat composition can also be used, to the extent that the effects of the present invention are not impaired. The content of components other than the oils and/or fats is preferably 20% by mass or less, and more preferably 5% by mass or less.

Also, as the oil/fat composition held in the container for holding an oil/fat composition, for example, those containing water in addition to oils and/or fats may be mentioned, and there are separated dressings, emulsified dressings, and the like. As the separated dressing, a Japanese-style dressing, a French dressing, or the like can be used, and as the emulsified dressing, a sesame-flavored dressing, mayonnaise, a mayonnaise-type dressing, or the like can be used.

[Method for Producing Container for Holding an Oil/Fat Composition]

The container for holding an oil/fat composition of the present invention can be produced by coating the container with a silicon oxide vapor-deposited film by a plasma CVD method using an organosilicon compound and an optional oxidizing gas as a reaction gas. Here, the ion intensity S, ion intensity A, ion intensity AO, and ion intensity B, and their ratios are as described in the aforementioned [Silicon Oxide Vapor-Deposited Film].

(Organosilicon Compound and Oxidizing Gas)

In the method for producing a container for holding an oil/fat composition of the present invention, an organosilicon compound is used as a silicon source for forming a silicon oxide vapor-deposited film. As the organosilicon compound, organic silane compounds (for example, hexamethyldisilane, vinyltrimethylsilane, methylsilane, dimethylsilane, tetramethylsilane, trimethylsilane, diethylsilane, propylsilane, phenylsilane, methyltriethoxysilane, vinyltriethoxysilane, vinyltrimethoxysilane, tetramethoxysilane, tetraethoxysilane, phenyltrimethoxysilane, methyltrimethoxysilane, and methyltriethoxysilane, and the like), and organic siloxane compounds (for example, octamethylcyclotetrasiloxane, 1,1,3,3-tetramethyldisiloxane, hexamethyldisiloxane, and the like), diethoxydimethylsilane, dimethoxydimethylsilane, and the like are used. Also, in addition to these materials, silazanes such as hexamethyldisilazane, aminosilanes, and the like can also be used. These organosilicon compounds can be used alone or in combination of two or more. Also, silane ($SiH_4$) or silicon tetrachloride can be used in combination with the aforementioned organosilicon compounds. Regarding the organic functional group possessed by the organosilicon compound, an organosilicon compound having only a functional group selected from a methyl group, a methoxy group, an ethyl group, and an ethoxy group is preferable; an organosilicon compound having an ethoxy group and/or a methoxy group is more preferable; and an organosilicon compound having only an ethoxy group is still more preferable. Furthermore, an organosilicon compound having only a methyl group is also particularly preferable. Tetraethoxysilane, tetramethoxysilane, hexamethyldisilazane, hexamethyldisiloxane, and the like are preferable, and only hexamethyldisiloxane or an organosilicon compound containing hexamethyldisiloxane is more preferable.

As the oxidizing gas, oxygen or NOx is used, and oxygen is preferable. Note that a noble gas such as argon or helium is used as a carrier gas or a gas for stabilizing discharge.

In the method for producing a container for holding an oil/fat composition of the present invention, it is preferable to coat the container for holding an oil/fat composition with a silicon oxide vapor-deposited film by a plasma CVD method in which a ratio of a flow rate (volume) of the oxidizing gas to a total flow rate (volume) of the reaction gas is 0 to 95 vol%. By setting such conditions, a silicon oxide vapor-deposited film particularly excellent in roll-off property for oils and/or fats can be obtained. The ratio of the flow rate (volume) of the oxidizing gas to the total flow rate (volume) of the reaction gas is more preferably 1 to 65 vol% or 1 to 60 vol%, still more preferably 2 to 40 vol% or 2 to 30 vol%, and most preferably 5 to 10 vol%. Note that the flow rate of the reaction gas depends on the coating area in the container for holding an oil/fat composition to be treated, but for example, when coating the inner surface of a plastic container with a capacity of 400 mL to 1.5 L, it is preferably supplied at a flow rate of 3 to 2000 sccm, particularly 5 to 600 sccm per container. Note that "sccm" means the amount of gas (cc or ml) flowing per minute at 0°C and 1 atmosphere.

(Plasma CVD Method)

In the present invention, plasma treatment by a plasma CVD method is performed on the surface of a substrate held in a plasma treatment chamber in an atmosphere containing the aforementioned organosilicon compound, an optional oxidizing gas, and a carrier gas as necessary, to form a vapor-deposited film with the aforementioned composition.

During the plasma treatment, in order to maintain the plasma treatment chamber at a degree of vacuum where a glow discharge occurs, the pressure during film formation is preferably 1 to 200 Pa, and more preferably 3 to 100 Pa. In this state, a silicon oxide vapor-deposited film is formed by glow discharge by supplying microwaves (300 MHz to 300 GHz), high frequencies (1 to 300 MHz), or the like. For example, the output of microwaves is preferably in a range of 10 to 1000 W, and more preferably 20 to 1000 W. The frequency of microwaves is preferably 500 MHz to 30 GHz, more preferably 1 to 10 GHz, and still more preferably 1 to 5 GHz. The output of high frequencies is preferably 20 to 1500 W, and more preferably 30 to 1500 W. The frequency of high frequencies is preferably 1 to 100 MHz, more preferably 1 to 30 MHz, and still more preferably 10 to 15 MHz.

Note that in the method for producing a container for holding an oil/fat composition of the present invention, it is sufficient that the outermost layer of the inner surface of the container for holding an oil/fat composition is a silicon oxide vapor-deposited film coated under the above conditions, and a container for holding an oil/fat composition coated under other conditions may be further coated under the above production conditions. Also, the conditions of the plasma CVD method may be changed, such as by changing the supply amount of the oxidizing gas, and the coating may be finally performed under the above production conditions.

Examples

Next, the present invention will be described in more detail by giving Examples, Comparative Examples, and Reference Examples, but the present invention is not limited thereto in any way. Also, hereinafter, "%" indicates % by mass unless otherwise specified.

Note that in the tables, "(A+AO)/S" means "(ion intensity A+ion intensity AO)/ion intensity S," "A/S" means "ion intensity A/ion intensity S," "AO/S" means "ion intensity AO/ion intensity S," "AO/A" means "ion intensity AO/ion intensity A," and "AO/B" means "ion intensity AO/ion intensity B."

[Comparative Examples 1 to 3 and Examples 1 to 4]

(Plasma CVD Apparatus 1)

The film formation conditions using the plasma CVD apparatus 1 used in the Comparative Examples and Examples are as shown in Table 1. The settings of the plasma CVD apparatus 1 other than those in Table 1 are as follows.

Name: Plasma CVD apparatus 1
Film formation method: PECVD (Plasma Enhanced Chemical Vapor Deposition)
Plasma source: CCP (Capacitively Coupled Plasma)
Electrode shape: Conformal type (conforming to the container shape)
External RF electrode: Upper and lower 2-piece structure, no cooling mechanism
Internal gas introduction electrode: $\varphi$6.35 mm, no heating mechanism
Material: Aluminum alloy (external electrode), SUS304 (internal electrode)
RF power supply: Frequency 13.56 MHz
RF switcher: For 2ch
Matching method: Automatic impedance matching
Exhaust configuration: Mechanical booster pump (main exhaust), Rotary pump (auxiliary)
Exhaust manifold external dimensions: 350 mm x 350 mm x H150 mm

(Preparation 1 of Container for Holding an Oil/Fat Composition having Silicon Oxide Vapor-Deposited Film on Inner Surface)

An uncoated commercially available polyethylene terephthalate container for edible oils and/or fats (PET container: usable capacity 600 g, inner diameter of the upper opening 27.6 mm, height 218.7 mm) was designated as Comparative Example 1. For the container of Comparative Example 1, using the plasma CVD apparatus 1 (details above), by performing plasma treatment under the film formation conditions of Table 1, the PET container was coated with a silicon oxide vapor-deposited film to obtain container samples (samples of containers for holding an oil/fat composition) of Comparative Example 2 and Examples 1 to 3.

Specifically, for the container samples of Comparative Example 2 and Examples 1 to 3, hexamethyldisiloxane (hereinafter sometimes referred to as HMDSO) or tetramethoxysilane (hereinafter sometimes referred to as TMOS) was used as an organosilicon compound. If necessary, oxygen ($O_2$) was mixed with the organosilicon compound as an oxidizing gas and used as a reaction gas. Also, if necessary, argon (Ar) was used as a gas for stabilizing discharge. First, the PET container was set in the plasma treatment chamber of the plasma CVD apparatus 1, and after reducing the pressure in the plasma treatment chamber to 1 Pa or less, the reaction gas and optionally the gas for stabilizing discharge (Ar) were introduced into the plasma treatment chamber at the flow rates described in Table 1, and after stabilizing the pressure to the pressure described in Table 1 over 30 seconds to 60 seconds, discharge was performed for the time described in Table 1 with the plasma power described in Table 1 to coat the surface of the PET container with a silicon oxide vapor-deposited film. After the discharge, the introduction of the reaction gas and the optional gas for stabilizing discharge was stopped, and after reducing the pressure in the film formation chamber to 1 Pa or less, the plasma treatment chamber was vented to the atmosphere, and the PET container was taken out from the plasma treatment chamber.

Under the above conditions, a plurality of PET containers coated with a silicon oxide vapor-deposited film were produced, and the ion intensity and its ratio, roll-off property, and residual oils and/or fats amount (reduction ratio of residual oils and/or fats amount) were analyzed and evaluated according to the following analysis methods. The analysis and evaluation results are shown in Tables 2 and 3.

[Analysis Method]

(Roll-off property of Oils and/or Fats 1)

The containers for holding an oil/fat composition of the Examples and Comparative Examples (container samples) were placed horizontally, and from the opening of the container, one drop (about 24.36 mg) of refined rapeseed oil ("Nisshin Canola Oil" manufactured by The Nisshin OilliO Group, Ltd., 99.9%) colored with carotene ("β-Carotene 30% FS" manufactured by DMS, 0.1%) was dropped onto the flat part of the container with a dropper. Immediately, the sample was placed on a stage ("Stage (angle tilt)" manufactured by AS ONE Corporation) set at an inclination of 70° with respect to the vertical, and the time for the rear end of the oil and/or fat droplet (the uppermost point of contact between the sample surface and the oil and/or fat droplet on the inclined sample surface) to move 6 mm on the sample surface was measured. Note that the temperature during the measurement was room temperature (23°C).

Based on the movement time, an evaluation was performed based on the following criteria of A to E, and if it was A to D, the evaluation sample was considered to have the roll-off property of the oils and/or fats. Also, here, it can be determined that the shorter the movement time, the better the roll-off property of the oils and/or fats.

Evaluation A: no more than 10 seconds
Evaluation B: more than 10 seconds to 20 seconds
Evaluation C: more than 20 seconds to 60 seconds
Evaluation D: more than 60 seconds to 300 seconds
Evaluation E: more than 300 seconds

Reference (Influence of Presence or Absence of Carotene)

A 2 cm square PET plate was cut out from the flat part of the container for holding an oil/fat composition of Example 1 to be used as a sample. The sample was placed on a stage ("Stage (angle tilt)" manufactured by AS ONE Corporation) set at an inclination of 70° with respect to the vertical, and a mixture of refined rapeseed oil ("Nisshin Canola Oil" manufactured by The Nisshin OilliO Group, Ltd., 99.9% by mass) colored with carotene ("β-Carotene 30% FS" manufactured by DMS, 0.1% by mass) and refined rapeseed oil only ("Nisshin Canola Oil" manufactured by The Nisshin OilliO Group, Ltd., 100% by mass) were each dropped onto the sample surface with a dropper, one drop (about 24.36 mg), and the time for the rear end of the oil and/or fat droplet (the uppermost point of contact between the sample surface and the oil and/or fat droplet on the inclined sample surface) to move 6 mm on the sample surface was measured. Note that the temperature during the measurement was room temperature (23°C).

In both cases, the result was 5 seconds, the same as the result for Example 1 in Table 3.

This confirmed that neither the sample's inclination at the time of depositing the rapeseed oil onto the sample surface nor the presence of β-carotene affected the measured roll-off time.

(Reduction Ratio of Residual Oils and/or Fats Amount 1)

The containers for holding an oil/fat composition of the Examples and Comparative Examples were prepared as samples. After measuring the mass of the empty samples, 600 g of rapeseed oil was filled into the samples. As the rapeseed oil, refined rapeseed oil ("Nisshin Canola Oil" manufactured by The Nisshin OilliO Group, Ltd.) was used. The container was quickly inclined to an angle of 160° with respect to the vertical to discharge the rapeseed oil. The time when the rapeseed oil began to be discharged from the upper opening of the container was set to 0 seconds, and after 600 seconds had elapsed from that point, the inclination was returned to the original position, and the amount of rapeseed oil remaining in the container (residual oils and/or fats amount) was measured. The test was conducted at room temperature (23°C). Here, the reduction ratio of the residual oils and/or fats amount was calculated from the following formula, wherein the residual oils and/or fats amount of the container for holding an oil/fat composition of Comparative Example 1 was taken as B (% by mass), and the residual oils and/or fats amount of the container for holding an oil/fat composition of each of the other Examples or Comparative Examples was taken as A (% by mass):

$$\text{Reduction ratio of residual oils and/or fats amount (\%)} = (1 - A/B) \times 100$$

(Surface Functional Group Analysis)

Using a time-of-flight secondary ion mass spectrometer ("TOF.SIMS5" sold by Hitachi High-Tech Science Corporation, acceleration voltage: 30 kV, measurement area: 500 μm square, primary ion source: Bi (bismuth)), the inner surfaces of the samples of the containers for holding an oil/fat composition of the Examples and Comparative Examples were analyzed. From the ion intensities of the obtained peaks, the ratio of the sum of ion intensity A and ion intensity AO to ion intensity S ((ion intensity A+ion intensity AO)/ion intensity S), the ratio of ion intensity A to ion intensity S (ion intensity A/ion intensity S), the ratio of ion intensity AO to ion intensity S (ion intensity AO/ion intensity S), the ratio of ion intensity AO to ion intensity A (ion intensity AO/ion intensity A), and the ratio of ion intensity AO to ion intensity B (ion intensity AO/ion intensity B) were calculated.

Note that the intensity of an ion (ion intensity) mentioned here is a value that depends on the number of ions detected by time-of-flight secondary ion mass spectrometry (a value detected for each ion of each m/z). The ion intensity S was taken as the intensity of the positive ion at m/z 43.97, the ion intensity A was taken as the sum of the intensities of the positive ion at m/z 43.00, the positive ion at m/z 59.03, and the positive ion at m/z 73.05, the ion intensity AO was taken as the sum of the intensities of the negative ion at m/z 31.02, the negative ion at m/z 59.00, the negative ion at m/z 74.99, the positive ion at m/z 102.97, and the negative ion at m/z 134.96, and the ion intensity B was taken as the sum of the intensities of the positive ion at m/z 78.99 and the positive ion at m/z 138.95.

| Table 1 | Comparative Example 2 | Example 1 | Example 2 | Example 3 |
|---|---|---|---|---|
| Raw Material | HMDSO | HMDSO | HMDSO | TMOS |
| Raw Material Flow Rate [sccm] | 10 | 10 | 20 | 60 |
| Oxygen Flow Rate [sccm] | 50 | 0 | 200 | 0 |
| Ar Flow Rate [sccm] | 0 | 50 | 0 | 0 |
| Pressure [Pa] | 10 | 50 | 10 | 10 |
| Plasma Power [W] | 1000 | 100 | 300 | 1000 |
| Time [seconds] | 2 | 10 | 10 | 2 |

| Table 2 | Comparative Example 2 | Example 1 | Example 2 | Example 3 |
|---|---|---|---|---|
| Intensity of AO | 7075 | 39829 | 28459 | 16995 |
| Intensity of A | 52010 | 310300 | 63693 | 14212 |
| Intensity of B | 8427 | 3 | 2442 | 4778 |
| Intensity of S | 9751 | 9 | 1990 | 2306 |
| AO/B | 0.8 | 13276 | 11.7 | 3.6 |
| AO/A | 0.1 | 0.13 | 0.45 | 1.20 |
| (A+AO)/S | 6.1 | 41192 | 46.3 | 13.5 |
| AO/S | 0.7 | 4686 | 14.3 | 7.4 |
| A/S | 5.3 | 36506 | 32.0 | 6.2 |

| Table 3 | Roll-off property of Oils and/or Fats (seconds) | Roll-off property Judgment | Residual Oils and/or Fats Amount (after 600 seconds) | Ratio to Residual Oils and/or Fats Amount of Comparative Example 1 (Reduction Ratio of Residual Oils and/or Fats Amount) |
|---|---|---|---|---|
| Comparative Example 1 | >300 | E | 1.51 g | -(-) |
| Comparative Example 2 | >300 | E | 1.47 g | 97.4% (2.6%) |
| Example 1 | 5 | A | 0.12 g | 7.9% (92.1%) |
| Example 2 | 11 | B | 0.17 g | 11.3% (88.7%) |
| Example 3 | 37 | C | 0.73 g | 48.3% (51.7%) |

The roll-off property of Comparative Examples 1 to 2 was evaluated as E, and the residual oils and/or fats amount in the container after 600 seconds was also about 1.5 g. On the other hand, the roll-off property of Examples 1 to 3 was evaluated as A to C, and the residual oils and/or fats amount was also reduced by 50% by mass or more compared to Comparative Example 1, which was good.

[Comparative Examples 3 to 4 and Examples 4 to 5]

Using the container for holding an oil/fat composition of Comparative Example 1, in the measurement method for the reduction ratio of residual oils and/or fats amount described above, the rapeseed oil was replaced with olive oil (extra virgin olive oil, manufactured by The Nisshin OilliO Group, Ltd.), and the residual oils and/or fats amount was measured (Comparative Example 3). Also, using the container for holding an oil/fat composition of Example 1, the residual oils and/or fats amount was similarly calculated using olive oil (extra virgin olive oil, manufactured by The Nisshin OilliO Group, Ltd.), and the reduction ratio of the residual oils and/or fats amount was calculated (calculated by reading "Comparative Example 1" as "Comparative Example 3" in "Reduction Ratio of Residual Oils and/or Fats Amount 1" above) (Example 4).

Furthermore, using the container for holding an oil/fat composition of Comparative Example 1, in the measurement method for the reduction ratio of residual oils and/or fats amount described above, the rapeseed oil was replaced with cottonseed oil (refined cottonseed oil, manufactured by The Nisshin OilliO Group, Ltd.), and the residual oils and/or fats amount was measured (Comparative Example 4). Also, using the container for holding an oil/fat composition of Example 1, the residual oils and/or fats amount was similarly measured using cottonseed oil (refined cottonseed oil, manufactured by The Nisshin OilliO Group, Ltd.), and the reduction ratio of the residual oils and/or fats amount was calculated (calculated by reading "Comparative Example 1" as "Comparative Example 4" in "Reduction Ratio of Residual Oils and/or Fats Amount 1" above) (Example 5).

The results are shown in Table 4.

| Table 4 | Evaluation Oils and/or Fats | Residual Oils and/or Fats Amount (after 600 seconds) | Ratio to Residual Oils and/or Fats Amount of Comparative Example (Reduction Ratio) |
|---|---|---|---|
| Comparative Example 3 | Olive oil | 1.58 g | -(-) |
| Example 4 | Olive oil | 0.12 g | 7.6% (92.4%) |
| Comparative Example 4 | Cottonseed oil | 1.63 g | -(-) |
| Example 5 | Cottonseed oil | 0.14 g | 8.6% (91.4%) |

From the results of Table 4, it was confirmed that in Examples 4 and 5 using the container of Example 1, there is a similar effect of reducing the residual oils and/or fats amount not only for rapeseed oil but also for other vegetable oils.

[Comparative Example 5 and Examples 6 to 7]

(Plasma CVD Apparatus 2)

Plasma CVD apparatus 2 was used. As the plasma CVD apparatus, model number: PD-220NL, manufactured by SAMCO INC. (RF power supply: frequency 13.56 MHz) was used, and the conditions are as shown in Table 5.

Table 5

| Organosilicon Compound | TEOS |
|---|---|
| Organosilicon Compound Flow Rate [sccm] | 10.0 |
| $O_2$ Flow Rate [sccm] | 1 |
| Power [W] | 200 |
| Pressure [Pa] | 10 |
| Ar Flow Rate [sccm] | 0 |
| He Flow Rate [sccm] | 0 |
| Time [seconds] | 180 |

(Preparation 2 of Container for Holding an Oil/Fat Composition having Silicon Oxide Vapor-Deposited Film on Surface)

An uncoated commercially available polyethylene film used for pillow bags (low-density PE film: thickness 100 $\mu$m, manufactured by Toshin Kagaku Kogyo Co., Ltd.) was cut into a 14 cm square and designated as Comparative Example 5. An evaluation sample treated in the same manner as in Comparative Example 5 was coated with a silicon oxide vapor-deposited film using the plasma CVD apparatus 2 under the conditions of Table 5, and designated as Example 6.

Specifically, for the film sample of Example 6, tetraethoxysilane (hereinafter, TEOS) was used as the organosilicon compound. Also, oxygen ($O_2$) was used as the oxidizing gas. Also, if necessary, helium (He) was used as a carrier gas for TEOS. First, the film sample was set in the load-lock chamber of the plasma CVD apparatus 2, and after the load-lock chamber was evacuated, the film sample was moved to the plasma treatment chamber, and then the pressure in the plasma treatment chamber was reduced to $3 \times 10^{-3}$ Pa or less. Thereafter, the oxidizing gas was introduced into the plasma treatment chamber at the flow rate described in Table 5, and after stabilizing the pressure to the pressure described in Table 5 over 60 seconds to 90 seconds, the organosilicon compound was introduced into the plasma treatment chamber at the flow rate described in Table 5, and the pressure was stabilized again to the pressure described in Table 5 over 60 seconds.

Thereafter, discharge was performed for the time described in Table 5 with the plasma power described in Table 5 to coat the surface of the film sample with a silicon oxide vapor-deposited film. After the discharge, the introduction of the organosilicon compound and the oxidizing gas was stopped, and after reducing the pressure in the film formation chamber to 4x10$^{-3}$ Pa or less, the film sample was moved to the load-lock chamber, and then the load-lock chamber was vented to the atmosphere, and the film sample was taken out from the load-lock chamber.

Also, an evaluation sample treated in the same manner as in Comparative Example 5 was coated with a silicon oxide vapor-deposited film using the plasma CVD apparatus 1 used in Example 1 under the film formation conditions of Example 1 in Table 1, and designated as Example 7. Note that the conditions of the plasma CVD apparatus 1 used were changed to the following conditions for coating.

Film formation method: PECVD (Plasma Enhanced Chemical Vapor Deposition)
Plasma source: CCP (Capacitively Coupled Plasma)
Electrode shape: Parallel plate type, inter-electrode distance 50 mm
External RF electrode: SUS304 (lower electrode), aluminum alloy + SUS304 (upper electrode)
Lower RF electrode: Φ320 mm, water-cooled
Upper gas shower electrode: Φ320 mm, heated
Internal gas introduction electrode: φ6.35 mm, no heating mechanism
Material: Aluminum alloy (external electrode), SUS304 (internal electrode)
RF power supply: Frequency 13.56 MHz
RF switcher: For 2ch
Matching method: Automatic impedance matching
Exhaust configuration: Mechanical booster pump (main exhaust), Rotary pump (auxiliary)
Exhaust manifold external dimensions: 350 mm x 350 mm x H150 mm

The roll-off property of oils and/or fats of the obtained Comparative Example 5 and Examples 6 and 7 was analyzed and evaluated. Also, the film was formed into a pillow shape (dimensions: width 7 cm, height 14 cm, opening dimension: circumference 13 cm), and the reduction ratio of the residual oils and/or fats amount was evaluated according to the following. The analysis and evaluation results are shown in Table 6.

[Analysis Method]

(Roll-off property of Oils and/or Fats 2)

On the film used as a starting material in "Preparation 2 of Container for Holding an Oil/Fat Composition having Silicon Oxide Vapor-Deposited Film on Surface" above, one drop (about 24.36 mg) of refined rapeseed oil ("Nisshin Canola Oil" manufactured by The Nisshin OilliO Group, Ltd., 99.9%) colored with carotene ("β-Carotene 30% FS" manufactured by DMS, 0.1%) was dropped with a dropper. Immediately, the sample was placed on a stage ("Stage (angle tilt)" manufactured by AS ONE Corporation) set at an inclination of 70° with respect to the vertical, and the time for the rear end of the oil and/or fat droplet (the uppermost point of contact between the sample surface and the oil and/or fat droplet on the inclined sample surface) to move 6 mm on the sample surface was measured. Note that the temperature during the measurement was room temperature (23°C).

Based on the movement time, an evaluation was performed based on the following criteria of A to E, and if it was A to D, the evaluation sample was considered to have roll-off property and/or oil repellency for oils and/or fats. Also, here, it can be determined that the shorter the movement time, the higher and better the roll-off property and/or oil repellency for oils and/or fats.

Evaluation A: no more than 10 seconds
Evaluation B: more than 10 seconds to 20 seconds
Evaluation C: more than 20 seconds to 60 seconds
Evaluation D: more than 60 seconds to 300 seconds
Evaluation E: more than 300 seconds

(Reduction Ratio of Residual Oils and/or Fats Amount 2)

After measuring the mass of an empty sample of a film formed into a pillow shape (commercially available polyethylene film (low-density PE film: thickness 100 μm, manufactured by Toshin Kagaku Kogyo Co., Ltd., dimensions: width 7 cm, height 14 cm, opening dimension: circumference 13 cm)), 50 g of rapeseed oil was filled. As the rapeseed oil, refined rapeseed oil ("Nisshin Canola Oil" manufactured by The Nisshin OilliO Group, Ltd.) was used. The film was quickly inclined to an angle of 180° with respect to the vertical, and the rapeseed oil was discharged from the opening of the pillow-shaped film. The time when the rapeseed oil began to be discharged from the upper opening of the pillow-shaped film was set to 0 seconds, and after 90 seconds had elapsed from that point, the inclination was returned to the original position, and the amount of rapeseed oil remaining in the pillow-shaped film (residual oils and/or fats amount) was measured. The test was conducted at room temperature (23°C). Here, the reduction ratio of the residual oils and/or fats amount was calculated from the following formula, wherein the residual oils and/or fats amount of the container for holding an oil/fat composition of Comparative Example 5 was taken as B (% by mass), and the residual oils and/or fats amount of the pillow-shaped film of each of the other Examples was taken as A (% by mass):

$$\text{Reduction ratio of residual oils and/or fats amount (\%)} = (1-A/B) \times 100$$

Table 6

| | Roll-off property (seconds) | Roll-off property Judgment | Residual Oils and/or Fats Amount (after 90 seconds) | Ratio to Residual Oils and/or Fats Amount of Comparative Example 5 (Reduction Ratio of Residual Oils and/or Fats Amount) |
|---|---|---|---|---|
| Comparative Example 5 | >300 | E | 1.04 g | -(-) |
| Example 6 | 5 | A | 0.22 g | 21.2% (78.8%) |
| Example 7 | 5 | A | 0.28 g | 26.9% (73.1%) |

Examples of Glass and Metal

(Preparation of Silicon Oxide Vapor-Deposited Film and Container for Holding an Oil/Fat Composition)

A glass petri dish (Petri dish, manufactured by Kenis, product number: NOR-100, dimensions: diameter 100 mm, height 16 mm) and a metal stainless steel petri dish (manufactured by Kenis, dimensions: diameter 90 mm, height 20 mm) were designated as Comparative Examples 6 and 7, respectively. The petri dishes of Comparative Examples 6 and 7 were subjected to plasma treatment with the same apparatus and under the same film formation conditions as in Example 7, thereby being coated with a silicon oxide vapor-deposited film, and were designated as Examples 8 and 9, respectively.

Under the above conditions, petri dishes coated with a silicon oxide vapor-deposited film were produced, and the roll-off property of oils and/or fats and the residual oils and/or fats amount (reduction ratio of residual oils and/or fats amount) were analyzed and evaluated. The analysis and evaluation results are shown in Table 7.

[Analysis Method]

(Roll-off property of Oils and/or Fats 3)

On the bottom surface of the petri dishes of Comparative Examples 6 and 7 and Examples 8 and 9 above, one drop (about 24.36 mg) of refined rapeseed oil ("Nisshin Canola Oil" manufactured by The Nisshin OilliO Group, Ltd., 99.9%) colored with carotene ("β-Carotene 30% FS" manufactured by DMS, 0.1%) was dropped with a dropper. Immediately, the sample was placed on a stage ("Stage (angle tilt)" manufactured by AS ONE Corporation) set at an inclination of 70° with respect to the vertical, and the time for the rear end of the oil and/or fat droplet (the uppermost point of contact between the sample surface and the oil and/or fat droplet on the inclined sample surface) to move 6 mm on the sample surface was measured. Note that the temperature during the measurement was room temperature (23°C).

Based on the movement time, an evaluation was performed based on the following criteria of A to E, and if it was A to D, the evaluation sample was considered to have roll-off property and/or oil repellency for oils and/or fats. Also, here, it can be determined that the shorter the movement time, the higher and better the roll-off property and/or oil repellency for oils and/or fats.

Evaluation A: no more than 10 seconds
Evaluation B: more than 10 seconds to 20 seconds
Evaluation C: more than 20 seconds to 60 seconds
Evaluation D: more than 60 seconds to 300 seconds
Evaluation E: more than 300 seconds

(Reduction Ratio of Residual Oils and/or Fats Amount 3)

50 g of rapeseed oil was filled into the petri dishes of Comparative Examples 6 and 7, and Examples 8 and 9 above. As the rapeseed oil, refined rapeseed oil ("Nisshin Canola Oil" manufactured by The Nisshin OilliO Group, Ltd.) was used. The petri dish was quickly inclined so that the bottom surface was 45° downward from the vertical with respect to the ground, and the rapeseed oil was discharged. The time when the rapeseed oil began to be discharged from the upper opening of the petri dish was set to 0 seconds, and after 90 seconds had elapsed from that point, the inclination was returned to the original position, and the amount of rapeseed oil remaining in the petri dish (residual oils and/or fats amount) was measured. The test was conducted at room temperature (23°C). Here, the reduction ratio of the residual oils and/or fats amount was calculated from the following formula, wherein the residual oils and/or fats amount of the container for holding an oil/fat composition of Comparative Example 6 was taken as B (% by mass), and the residual oils and/or fats amount of the petri dish of Example 8 was taken as A (% by mass). Also, similarly, the reduction ratio of the residual oils and/or fats amount was calculated from the following formula in the same manner as above, wherein the residual oils and/or fats amount of the container for holding an oil/fat composition of Comparative Example 7 was taken as B (% by mass), and the residual oils and/or fats amount of the petri dish of Example 9 was taken as A (% by mass):

$$\text{Reduction ratio of residual oils and/or fats amount } (\%) = (1 - A/B) \times 100$$

Table 7

|  | Roll-off property (seconds) | Roll-off property Judgment | Residual Oils and/or Fats Amount (after 90 seconds) | Ratio to Residual Oils and/or Fats Amount of Comparative Example 6 or 7 (Reduction Ratio of Residual Oils and/or Fats Amount) |
|---|---|---|---|---|
| Comparative Example 6 (Glass) | >300 | E | 0.44 g | -(-) |
| Example 8 (Glass) | 8 | A | 0.09 g | 20.5% (79.5%) |
| Comparative Example 7 (Metal) | >300 | E | 0.50 g | -(-) |
| Example 9 (Metal) | 6 | A | 0.03 g | 6.0% (94.0%) |

**Claims**

1. A container for holding an oil/fat composition, comprising a silicon oxide vapor-deposited film on an inner surface thereof, wherein a roll-off property of oils and/or fats on the inner surface of the container according to the following definition is 300 seconds or less:
Roll-off property of oils and/or fats: time (seconds) for an oil and/or fat droplet of rapeseed oil having a mass of $24 \pm 0.5$ mg to move 6 mm on a sample surface inclined at 70° with respect to the vertical at $23 \pm 3$°C.

2. The container for holding an oil/fat composition according to claim 1, wherein a reduction ratio of a residual oils and/or fats amount of the container according to the following definition is 20% by mass or more:

Reduction ratio of residual oils and/or fats amount: a value that satisfies the following formula, wherein A is the amount (% by mass) of the oil/fat composition remaining in the container 600 seconds after the oil/fat composition starts discharging from an opening of the container when the container filled with the oil/fat composition is inclined to 160° with respect to the vertical; and
B is the amount (% by mass) of the oil/fat composition, measured in the same manner, remaining in a container identical to the container for holding an oil/fat composition except that it does not have a silicon oxide vapor-deposited film on an inner surface:

$$\text{Reduction ratio of residual oils and/or fats amount } (\%) = (1 - A/B) \times 100$$

3. The container for holding an oil/fat composition according to claim 1 or 2, wherein the container for holding an oil/fat composition is formed from a material selected from the group consisting of resin, glass, paper, and metal.

4. The container for holding an oil/fat composition according to any one of claims 1 to 3, wherein the silicon oxide vapor-deposited film is a film derived from hexamethyldisiloxane.

5. The container for holding an oil/fat composition according to any one of claims 1 to 4, wherein an oil/fat composition is held.

## INTERNATIONAL SEARCH REPORT

| | |
|---|---|
| | International application No. |
| | **PCT/JP2024/022822** |

| | |
|---|---|
| **A.** | **CLASSIFICATION OF SUBJECT MATTER** |
| | *B65D 25/14*(2006.01)i; *B65D 65/40*(2006.01)i; *B65D 85/72*(2006.01)i; *C23C 16/42*(2006.01)i |
| | FI:   B65D25/14 Z; C23C16/42; B65D65/40 D; B65D85/72 |

According to International Patent Classification (IPC) or to both national classification and IPC

| | |
|---|---|
| **B.** | **FIELDS SEARCHED** |

Minimum documentation searched (classification system followed by classification symbols)

B65D25/14; B65D65/40; B65D85/72; C23C16/42

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| X | JP 2023-6873 A (YOSHINO KOGYOSHO CO., LTD.) 18 January 2023 (2023-01-18) paragraphs [0017], [0020], fig. 1, 2 | 1-5 |
| X | JP 2014-148332 A (YOSHINO KOGYOSHO CO., LTD.) 21 August 2014 (2014-08-21) paragraphs [0017], [0020], fig. 1 | 1-5 |

| | | | |
|---|---|---|---|
| ☐ Further documents are listed in the continuation of Box C. | | ☑ See patent family annex. | |

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **18 July 2024** | **30 July 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

| International application No. |
| --- |
| **PCT/JP2024/022822** |

| Patent document cited in search report | | Publication date (day/month/year) | Patent family member(s) | Publication date (day/month/year) |
| --- | --- | --- | --- | --- |
| JP | 2023-6873 A | 18 January 2023 | (Family: none) | |
| JP | 2014-148332 A | 21 August 2014 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000255579 A
- JP 2003053873 A
- JP 2009046162 A
- JP 2022162775 A